(19) Europäisches Patentamt
European Patent Office
Office européen des brevets

(11) Numéro de publication : 0 333 599 B1

(12) # FASCICULE DE BREVET EUROPEEN

(45) Date de publication du fascicule du brevet : **21.04.93 Bulletin 93/16**

(51) Int. Cl.$^5$ : **G06F 7/72**

(21) Numéro de dépôt : **89400762.4**

(22) Date de dépôt : **17.03.89**

(54) **Multiplieur-additionneur paramétrable dans les corps de Galois, et son utilisation dans un processeur de traitement de signal numérique.**

(30) Priorité : **17.03.88 FR 8803431**

(43) Date de publication de la demande : **20.09.89 Bulletin 89/38**

(45) Mention de la délivrance du brevet : **21.04.93 Bulletin 93/16**

(84) Etats contractants désignés : **DE ES FR GB IT NL**

(56) Documents cités :
**IEEE TRANSACTIONS ON COMPUTERS, vol. C-20, no. 7, juillet 1971, pages 1573-1578, IEEE, New York, US; B.A. LAWS, Jr. et al.: "A cellular-array multiplier for GF(2m)"**
**IEEE TRANSACTIONS ON COMPUTERS, vol. C-33, no. 4, avril 1984, pages 357-360, IEEE, New York, US; C.-S. YEH et al.: "Systolic multipliers for finite fields GF(2m)"**

(73) Titulaire : **THOMSON-CSF**
**51, Esplanade du Général de Gaulle**
**F-92800 Puteaux (FR)**

(72) Inventeur : **Cognault, Marc**
**Thomson-CSF SCPI Cedex 67**
**F-92045 Paris la Défense (FR)**
Inventeur : **Sanchez, José Joaquim**
**Thomson-CSF SCPI Cedex 67**
**F-92045 Paris la Défense (FR)**
Inventeur : **Brechard, Dominique**
**Thomson-CSF SCPI Cedex 67**
**F-92045 Paris la Défense (FR)**

(74) Mandataire : **Turlèque, Clotilde et al**
**THOMSON-CSF, SCPI, B.P. 329, 50, rue Jean-Pierre Timbaud**
**F-92402 Courbevoie Cédex (FR)**

EP 0 333 599 B1

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Jouve, 18, rue Saint-Denis, 75001 PARIS

## Description

L'invention se rapporte au domaine des télécommunications numériques, et plus particulièrement au traitement de signal numérique nécessaire dans ce type d'applications.

Les télécommunications numériques sont soumises à des perturbations qui nécessitent une protection efficace de l'information par codage au moyen de codes détecteurs et correcteurs d'erreurs.

Des codes particulièrement intéressants pour ce type de détection et correction d'erreurs sont les codes de type Reed Solomon (RS) ou BCH qui offrent un équilibre raisonnable entre la complexité de mise en oeuvre et l'efficacité. Ces codes font appel à des traitements de polynômes à valeurs dans les corps de Galois.

La publication de demande Européenne EP-A-265336 au nom de la demanderesse décrit un opérateur polynomial dans les corps de Galois et un processeur de traitement de signal numérique utilisant un tel opérateur. L'élément central d'un tel opérateur est un circuit multiplieur-additionneur effectuant les opérations de multiplication et d'addition de polynômes dans les corps de Galois. Le multiplieur-additionneur décrit dans cette demande n'était pas optimisé, tant par le nombre de niveaux logiques nécessaires au calcul que par la surface de l'opérateur, d'où une durée de calcul et un encombrement trop importants.

On connaît par ailleurs, par un article de B.A. LAWS Jr et al intitulé "A cellular-array multiplier for GF(2m)", pages 1575-1578 du Vol. C20, n°12, Décembre 1971 de IEEE Transactions on computers, un multiplieur-additionneur de type matriciel utilisant une décomposition de l'opération polynomiale P = A∗B+C qui effectue un calcul itératif au moyen d'une structure matricielle carrée.

L'invention a pour objet un multiplieur-additionneur programmable dans les corps de Galois simple et paramétrable, à vitesse de traitement plus rapide, cet opérateur pouvant traiter tous les corps de Galois jusqu'à $CG(2^N)$, N étant déterminé au départ par le concepteur.

Suivant l'invention, un multiplieur-additionneur paramétrable dans les corps de Galois jusqu'à $CG(2^N)$ où N est un entier prédéterminé, à trois entrées multiples destinées à recevoir les coefficients de polynômes opérandes A, B, C, de degré m-1 inférieur à N pour l'opération polynomiale P dans le corps de Galois de degré m, $CG(2^m)$ : P = (A ∗ B) + C, où ∗ et + sont respectivement la multiplication et l'addition, effectuées Modulo G, dans le corps de Galois $CG(2^m)$ de polynôme générateur G, et une entrée de données paramétrable, pour ce polynôme générateur, comportant :

- un décodeur constitué d'une ligne de N cellules élémentaires identiques $CD_j$, ordonnées de j = 0 à N-1, recevant les coefficients du polynôme générateur G(N:0) et transmettant les coefficients de ce polynôme sans celui de degré le plus élevé G(N-1:0) et un polynôme à un coefficient significatif déduit par combinaison logique du polynôme générateur marquant le degré m du corps de Galois choisi, DG(N-1:0) ;
- une matrice de calcul constituée de p lignes de cellules de calcul élémentaires identiques pour effectuer le calcul polynomial en p étapes, les cellules de la dernière ligne fournissant les termes de degrés 0 à m-1 du polynôme résultat P,

  est caractérisé en ce que, pour un calcul en p = 2N-1 étapes, la matrice de calcul comporte 2n-1 lignes de i = 0 à 2(N-1) et N colonnes de j = 0 à N-1 de cellules $CM_{i,j}$ connectées de manière arborescente, les entrées non connectées recevant des niveaux "0" logique, chaque cellule élémentaire de calcul $MC_{i,j}$ comportant :
- cinq entrées verticales reliées aux sorties verticales de la cellule précédente de la même colonne, recevant les termes de degré j, G(j) DG(j) et B(j) du polynôme générateur, du polynôme degré, et du polynôme B, le terme de degré i-j du polynôme A, et le terme de degré j d'un résultat intermédiaire $z^{i-1}(j)$, deux entrées latérales recevant de la cellule de la colonne de rang inférieur de la même ligne le terme de degré j-1 du résultat intermédiaire $z^{i-1}(j-1)$ et le terme de degré (i + 1 - j), A(i + 1 - j), du polynôme A,
- deux sorties latérales à destination de la cellule de rang supérieur de la même ligne fournissant le terme de degré j du résultat intermédiaire $z^{i-1}(j)$ et le terme de degré i-j, A(i-j) du polynôme A.

L'invention a également pour objet l'utilisation d'un tel multiplieur-additionneur, programmable dans les corps de Galois, dans un processeur de traitement de signal numérique.

L'invention sera mieux comprise et d'autres caractéristiques apparaîtront à l'aide de la description qui suit en référence aux figures annexées.

La figure 1 est le schéma synoptique d'un type de multiplieur-additionneur dans le corps de Galois ;

La figure 2 est un schéma du décodeur du polynôme générateur ;

La figure 3 est un schéma de la cellule élémentaire de ce décodeur ;

La figure 4 est le schéma d'un mode de réalisation de la matrice de calcul selon l'art antérieur ;

La figure 5 est le schéma de la cellule logique élémentaire correspondante ;

La figure 6 est le schéma de la cellule logique élémentaire utilisée dans la matrice de calcul selon l'invention ;

La figure 7 est le schéma de la matrice de calcul selon l'invention.

Un corps de Galois est défini par sa taille, c'est-à-dire par le nombre de bits des opérandes à traiter, et donc des résultats obtenus, et par son polynôme générateur. Soient A,B, et C trois polynômes d'un corps de Galois, et G son polynôme générateur :

G est le polynôme binaire de degré m générateur du corps de Galois correspondant, qui fixe la taille du corps de Galois dans lequel sont réalisées les opérations polynomiales ;

A,B,et C sont aussi des polynômes binaires de degré m-1. Soit z l'élément générateur du corps de Galois qui est racine du polynôme générateur G de degré m : l'élément nul et $z^i$ de i = 0 à $2^m$- 2 sont les $2^m$ éléments du corps de Galois CG($2^m$) et sont les M = $2^m$ symboles de m bits utilisés pour la transmission. Toute opération dans ce corps génère nécessairement un élément du corps, et ces opérations peuvent s'écrire de manière générale :

$$P = (A * B)_{\text{modulo } G} + C$$

où * est la multiplication dans le corps de Galois (utilisant des opérations élémentaires ET logique) et où + est l'addition dans le corps de Galois (OU exclusif logique),

Par simple décomposition, comme décrit par exemple dans l'article précité, les polynômes A, B, C et G peuvent s'écrire de la manière suivante :

$$A = a_0 + a_1 z + a_2 z^2 + \dots a_i z^i + \dots a_{m-1} z^{m-1} = \sum_{i=0}^{m-1} a_i z^i$$

$$B = \sum_{i=0}^{m-1} b_i z^i \quad ; \quad C = \sum_{i=0}^{m-1} c_i z^i \quad ; \quad G = \sum_{i=0}^{m} g_i z^i = 0.$$

Le coefficient de degré m le plus élevé du polynôme G est toujours égal à 1 :$g_m$ = 1.

En conséquence le résultat P peut être présenté de la manière suivante :

$$P = \left( \sum_{i=0}^{m-1} b_i z^i A \right)_{\text{modulo } G} + C$$

$$= \sum_{i=0}^{m-1} b_i (Az^i)_{\text{modulo } G} + C$$

$$= \sum_{i=0}^{m-1} b_i A_i + C, \text{ avec } A_i = (Az^i)_{\text{modulo } G}$$

Le résultat P développé donne alors :

$$P = C + b_0 A_0 + b_1 A_1 + \dots b_i A_i + \dots + b_{m-1} A_{m-1}$$

Le calcul du produit se décompose en une somme de produits partiels successifs :

$$P_{-1} = C$$
$$P_0 = P_{-1} + b_0A_0$$
$$P_1 = P_0 + b_1A_1$$
$$\text{-----------------}$$
$$P_i = P_{i-1} + b_iA_i \qquad (1)$$
$$\text{-----------------}$$
$$P_{m-1} = P_{m-2} + b_{m-1}A_{m-1} = P.$$

Le calcul des $A_i$ s'exécute suivant la séquence suivante :

$$A_0 = A$$
$$A_1 = (Az)_{\text{modulo } G}$$
$$A_2 = (Az^2)_{\text{modulo } G} = (A_1z)_{\text{modulo } G}$$
$$A_i = (Az^i)_{\text{modulo } G} = (Az^{i-1}z)_{\text{modulo } G}$$
$$= (A_{i-1}z)_{\text{modulo } G}$$

- Si le terme de plus haut degré est égal à 0 :$A_i=A_{i-1}z$
- Si le terme de plus haut degré est non nul : $A_i = A_{i-1}z + G$.

Ces deux expressions peuvent être écrites simultanément, sous la forme :

$$A_i = A_{i-1}z + (G \text{ AND } A_{i-1}(m-1) \qquad (2)$$

avec $A_i(m-1)$ coefficient du terme de degré le plus élevé du polynôme $A_{i-1}$.

D'une manière générale un multiplieur-additionneur utilise les expressions décrites ci-dessus pour effectuer les opérations nécessaires au codage et au décodage dans un corps de Galois CG($2^m$) où m est programmable jusqu'à m = N au moyen d'une structure matricielle : La figure 1 est le schéma synoptique d'un tel multiplieur-additionneur. Il se compose de deux parties essentielles :

- un décodeur 10 du polynôme générateur G, qui a pour entrée le polynôme générateur G (sur N+1 fils) de degré m compris entre 0 et N, N étant le degré maximal du corps de Galois dans lequel le multiplieur-additionneur est susceptible de travailler, et pour sortie le même polynôme générateur, mais sans son bit de plus fort poids qui n'est pas nécessaire au calcul, soit G(N-1:0) (sur N fils) et également comme autre sortie un polynôme degré, DG qui marque le terme de degré m du polynôme générateur du corps de Galois utilisé ;
- Une matrice de calcul 20, qui a pour entrées les opérandes polynomiaux A, B, C, ainsi que les sorties du décodeur, G(N-1 :0), et DG(N-1:0), et pour sortie le résultat P, ses différentes entrées et sorties étant des liaisons à N fils.

La notation G(N: O) indique une liaison à N+1 fils numérotés de 0 à N transmettant les différents coefficients du polynôme générateur G. La notation G(i) indique une liaison à 1 fil transmettant le coefficient de degré i du polynôme générateur G. Cette notation est utilisée ci-après et sur les figures pour les différentes entrées et sorties des circuits utilisés.

Le décodeur 10 du polynôme générateur est représenté plus en détails sur la figure 2. Il est constitué de N cellules élémentaires identiques $CD_0$, $CD_1$, ..., $CD_j$,... $CD_{N-1}$, et sa fonction consiste comme indiqué ci-dessus à transmettre les termes de degrés m-1 à 0 du polynôme générateur G vers la matrice de calcul et à détecter le degré de ce polynôme générateur.

La cellule de degré j, $CD_j$ du décodeur, est représentée en détails sur la figure 3. Cette cellule élémentaire comporte une entrée recevant le coefficient de degré j du polynôme générateur, G(j), et deux entrées reliées aux sorties de la cellule adjacente de degré j+1, G(j+1) et DD(j+1). A partir de ces trois entrées, la cellule du décodeur transmet le coefficient de degré j,G(j) d'une part à la cellule du décodeur de rang inférieur $CD_{j-1}$, et d'autre part à la sortie, à destination de la matrice de calcul 20. Elle forme le terme DD(j) au moyen d'une porte OU,11, dont les deux entrées sont reliées aux liaisons DD(j+1) et G(j+1) et dont la sortie est DD(j), et elle forme le terme DG(i) au moyen d'une porte ET dont une entrée reçoit G(j+1) et dont l'autre entrée, inversée reçoit DD(j+1). En sortie, le bit mis à 1 dans DG(N-1:0) pour indiquer le degré est le bit de rang m de G prélevé dans la cellule de rang m du décodeur du polynôme générateur. Le polynôme DG(N-1:0) n'a que son coefficient

de rang m-1 égal à 1 et G(N-1:0) est semblable à G(N:0) sans son coefficient de rang N :

| | N | N-1 | .... | m | .. m-1 | m-2 | .... 0 |
|---|---|---|---|---|---|---|---|
| G(N:0) | 0 | 0 | 0 | 1 | X | X | .... X |
| G(N-1:0) | | 0 | ...0 | 1 | X | X | .... X |
| DG(N-1:0) | | 0 | ...0 | 0 | 1 | 0 | .... 0 |

X représente 0 ou 1 suivant le corps de Galois dans lequel sont effectués les calculs. A titre d'exemple pour $CG(2^4)$ soit m = 4, G = (10011) que l'on écrit aussi sous forme polynomiale $G(X) = X^4 + X + 1$ et DG = (01000).

Dans un mode de réalisation connu par l'article précité, la matrice de calcul 20 est constituée d'un assemblage de cellules élémentaires identiques en N lignes de N cellules, formant N colonnes, le matriçage assurant automatiquement l'interconnexion des cellules.

Le schéma d'une telle matrice de calcul est représenté sur la figure 4, où les cellules $CC_{i,j}$ sont indexées par les rangs des lignes et des colonnes auxquelles elles appartiennent. Une ligne horizontale traite un mot, c'est-à-dire un polynôme. Elle reçoit de la ligne précédente de rang i-1 les résultats intermédiaires $A_{i-1}$ et $P_{i-1}$ définis ci-dessus, ainsi que le polynôme générateur G(N-1:0) et le degré du polynôme générateur DG(N-1:0) et fournit à la ligne suivante $A_i$, $P_i$, G et DG. Les bits $b_i$ du polynôme B sont distribués chacun sur une ligne horizontale B(i).

Chaque cellule sur une ligne i traite 1 bit. La cellule $CC_{i,j}$ située sur la ligne de rang i et sur la colonne de rang j reçoit de la cellule adjacente de la ligne précédente i-1, les bits de rang j du polynôme $A_{i-1}$, du polynôme DG, du polynôme G et du polynôme $P_{i-1}$, soient $A_{i-1}(j)$, DG(j), G(j), et $P_{i-1}(j)$. Elle reçoit également de la cellule adjacente de la colonne j-1 le terme $A_{i-1}(j-1)$ et transmet à la cellule adjacente de la colonne j+1 $A_{i-1}(j)$. Enfin une liaison horizontale transmet le terme de rang i de B, B(i) à toutes les cellules de la ligne et une autre ligne $R_i$ fournit une information décrite ci-après à toutes les cellules de cette même ligne.

La cellule élémentaire d'un tel mode de réalisation de la matrice de calcul est représentée sur la figure 5. Les différents bits ainsi appliqués à une cellule sont combinés logiquement au moyen de 5 portes élémentaires de la manière suivante:

- une porte trois états 21, reçoit $A_{i-1}(j)$ et son entrée de validation reçoit DG(j). Cette porte impose à sa sortie le bit $A_{i-1}(j)$ seulement pour la colonne j=m-1 où DG(j)=1, soit $A_{i-1}(m-1)$ ; la sortie de la porte trois états est reliée à la liaison entre cellules de la ligne i, $R_i$.
- une porte NON ET, 22 et une porte OU exclusif inversée 23 génèrent le résultat
  $$A_i(j) = A_{i-1}(j-1) + G(j)A_{i-1}(m-1),$$
  ce qui pour une ligne complète correspond à l'équation (2) mentionnée ci-dessus : pour cela les entrées de la porte 22 sont reliées aux lignes G(j) et $R_i$, et sa sortie est reliée à une entrée de la porte 23 dont autre entrée reçoit $A_{i-1}(j-1)$ ; la sortie de la porte 23 fournit $A_i(j)$.
- une porte NON ET 24 et une porte OU exclusif inversée 25 génèrent le résultat
  $$P_i(j) = P_{i-1}(j) + B(i)A_i(j),$$
  ce qui pour une ligne complète correspond à l'équation (1) mentionnée ci-dessus : pour cela la porte 24 reçoit B(i) et $A_i(j)$ sur ses deux entrées et sa sortie est reliée à une entrée de la porte 25 dont l'autre entrée reçoit $P_{i-1}(j)$.

Les bits G(j) et DG(j) sont transmis à la cellule adjacente suivante de la même colonne.

Comme indiqué ci-dessus, $P_{-1}$= C, c'est-à-dire que les entrées $P_{i-1}$ des cellules de la première ligne (rang 0) reçoivent les termes C(j) du polynôme C comme représenté sur la figure 4. Enfin les sorties P(N-1:0) des cellules de la $N^{ième}$ ligne sont les sorties de résultat.

Pour que le résultat du calcul obtenu à la dernière ligne de la matrice soit significatif, il faut que tous les opérandes A, B, C aient des degrés strictement inférieurs à celui du polynôme générateur G.

La caractéristique essentielle d'un tel type de multiplieur-additionneur, telle qu'elle ressort de la description ci-dessus du premier mode de réalisation, est qu'après décodage du polynôme générateur G, de degré au plus égal à N, et utilisation d'une matrice de cellules élémentaires identiques, il est possible d'effectuer des calculs dans tous les corps de Galois jusqu'à $CG(2^N)$. Ce mode de réalisation utilise une matrice de cellules élémentaires, de dimensions NxN, le schéma logique de la cellule comportant une porte 3 états, deux portes NON ET et deux portes OU exclusifs, et des interconnexions entre cellules telles que définies ci-dessus.

Mais, dans ce mode de réalisation de type connu, le polynôme générateur intervient à chaque étape dans

le calcul des Ai ; ce qui conduit à des temps de calcul importants.

L'invention a pour objet un multiplieur-additionneur paramétrable dans les corps de Galois dans lequel la vitesse de traitement est privilégiée, cet opérateur est décrit ci-après en référence aux figures 6 et 7, à partir d'une analyse différente :

Le produit $P=(A*B)_{modulo\ G}+C$ peut s'écrire de la manière suivante :

$$P=\left(\sum_{i=0}^{2(m-1)} \left(\sum_{j=0}^{i} b_j a_{i-j}\right) z^i\right)_{modulo\ G} + C$$

$$P=\sum_{i=0}^{2(m-1)} Z_i (z^i)_{modulo\ G} + C$$

avec

$$Z_0 = a_0 b_0$$
$$Z_1 = a_0 b_1 + a_1 b_0$$
$$Z_2 = a_0 b_2 + a_1 b_1 + a_2 b_0$$

-----------------------------

$$Z_i = \sum_{j=0}^{i} b_j a_{i-j}$$

-----------------------------

$$Z_{m-1} = a_{m-1} b_{m-1}$$

Le calcul des $z^i$ est effectué de la manière suivante :

$z^0=1$

$(z^i)_{modulo\ G} = z.z^{i-1}$ si le terme de poids fort est nul

$(z^i)_{modulo\ G} = z.z^{i-1}+G$ si le terme de poids fort n'est pas nul.

Le calcul des $Z_i$ est réalisé directement au moyen d'une matrice de cellules élémentaires dans laquelle les cellules utiles au calcul sont organisées et reliées suivant une structure arborescente pour qu'à chaque ligne i, on dispose du résultat intermédiaire Zi, des zones de câblage entre lignes et entre colonnes étant prévues dans la matrice comme décrit ci-après.

Le schéma logique de la cellule élémentaire $MC_{i,j}$ utilisée est représenté sur la figure 6, la matrice de calcul utilisant une matrice de N colonnes et 2N-1 lignes de cellules telles que celle représentée sur la figure 6.

La cellule élémentaire $MC_{i,j}$ de la colonne (j entre 0 et N-1) et de la ligne i(i entre 0 et 2N-2) a 5 entrées verticales respectivement pour B(j), $z^{i-1}$(j), DG(j) G(j) et A(i-j). L'entrée $z^{i-1}$(j) est utilisée pour la cellule adjacente $MC_{i,j+1}$ de la colonne j+1 au moyen d'une sortie horizontale, tandis que la cellule reçoit $z^{i-1}$(j-1) de la cellule adjacente de la colonne j-1, $MC_{i,j-1}$.

Comme dans la cellule élémentaire de calcul décrite antérieurement, une porte trois états 21 reçoit $z^{i-1}$(j), comme précédemment $A_{i-j}$(j) et est activée par DG(j). La seule porte activée est celle correspondant au degré le plus élevé du polynôme générateur, m-1, qui transfère $z^{i-1}$(m-1) sur la liaison horizontale $R_i$ traversant toutes les cellules de la ligne i. Cette sortie est reliée à l'entrée de la porte NON ET 22 dont l'autre l'entrée reçoit G(j) et dont la sortie est reliée à une première entrée de la porte OU exclusif inversée 23 ayant son autre entrée recevant $z^{i-1}$(j-1) de la cellule de rang précédent de la même ligne, et qui délivre sur une sortie verticale $z^i$(j).

De plus, chaque cellule comporte une porte ET, 26 relié aux entrées verticales A(i-j) et B(j) pour le calcul

d'un terme A(i-j) B(j) et une porte OU exclusif 27 dont les entrées et la sortie sont prises verticalement dans une première zone de câblage intercellules, horizontale, située au bas de la cellule pour le calcul des produits partiels $Z_i = \sum_{j=0}^{i} A(i-j)\,B(j)$ à partir des résultats intermédiaires..A(i-j) B(j)...

- De plus, chaque cellule comporte de la même façon une seconde porte ET 28 dont une entrée est reliée à la sortie de la porte OU exclusif inversée 23 qui fournit $z^i(j)$, et dont l'autre entrée est reliée à la liaison intercellules d'une même ligne dans la zone de câblage horizontale, $Z_i$, la sortie de cette porte ET 28 étant amenée à une zone de câblage verticale dans laquelle peut être calculée pour une colonne, $P(j) = \sum_i Z_i z^i(j)$. Pour cela chaque cellule comporte en outre une porte OU exclusif 29 qui prend ses entrées dans la zone de câblage verticale et dont la sortie est ramenée dans cette même zone de câblage.
- Enfin deux liaisons "obliques", sont prévues dans la cellule, l'une à partir de l'entrée verticale A(i-j) transmet ce bit A(i-j) par une connexion horizontale de sortie à la cellule de rang j+1 de la même ligne i, et l'autre transmet à partir de l'entrée A(i+1-j) provenant de la cellule précédente de la même ligne par une entrée horizontale, ce bit sur une sortie verticale A(i+1-j) de la cellule $MC_{i,j}$ à destination de la cellule suivante de la même colonne $MC_{i+1,j}$ ; ces liaisons permettent de constituer la structure arborescente utile dans l'interconnexion des cellules élémentaires ainsi décrites, comme représenté sur la figure 7.

Cette figure 7 représente la matrice de calcul correspondante pour un mode de réalisation où N = 4. Cette matrice comporte donc N = 4 colonnes (soit j = 0 à 4) et 2N-1 = 7 (soit i= 0 à 6) lignes de cellules élémentaires avec des zones d'interconnexion horizontales et verticales entre cellules d'une même ligne ou d'une même colonne. Par souci de simplification, les liaisons entre cellules n'ont pas toutes été représentées : seules ont été représentées les liaisons obliques qui mettent en évidence la structure arborescente de la matrice pour le calcul des produits $a_{i-j}b_j$ et les liaisons entre cellules réalisées à dans les zones de câblage horizontales et verticales réservées à cet effet pour le calcul

- des produits partiels $Z_i = \sum_j a_{i-j}b_j$ et des termes $P(j) = \sum_i Z_i z^i(j)$
- du produit résultat P(N-1:0).

Les notations du type $a_{i-j}b_j$ utilisent les coefficients des polynômes tels que définis initialement, et, les notations du type A(i-j)B(j) correspondent aux opérations réalisées avec les coefficients présents sur les entrées des matrices telles que définies ci-dessus. Ces notations sont à peu près équivalentes si ce n'est que lorsque l'on travaille dans un corps de Galois de degré inférieur au degré maximum possible, certaines entrées du type A(i), B(j), C(j) reçoivent des coefficients nuls.

Il résulte de ce qui précède que certaines cellules élémentaires ne sont pas utiles aux calculs des $a_{i-j}\,b_j$. C'est le cas des cellules élémentaires $MC_{i,j}$ pour i inférieur à j et i supérieur ou égal à j+4. Pour rendre la matrice strictement répétitive, ce qui facilite les procédés de fabrication correspondants, ces cellules n'ont pas été supprimées, les portes élémentaires inutiles sont rendues inopérantes par câblage de leurs entrées à un niveau inactif.

Ainsi comme il ressort de la description ci-dessus, le multiplieur-additionneur est paramétrable, par le polynôme générateur dont la valeur code l'ordre m du corps de Galois dans lequel sont effectuées les opérations polynomiales, m étant au plus égal à N.

L'opérateur utilise alors une matrice de calcul dont la taille est fonction du paramètre N ; cette matrice utilise une seule cellule de base pour les calculs et reçoit les données caractérisant le corps de Galois dans lequel sont effectuées les opérations par une matrice 1 x N constituée elle aussi d'un seul type de cellule.

## Revendications

1. Multiplieur-additionneur paramétrable dans les corps de Galois jusqu'à $CG(2^N)$ où N est un entier prédéterminé, à trois entrées multiples destinées à recevoir les coefficients de polynômes opérandes A, B, C, de degré m-1 inférieur à N pour l'opération polynomiale P dans le corps de Galois de degré m, $CG(2^m)$ : P = (A ∗ B) + C, où ∗ et + sont respectivement la multiplication et l'addition, effectuées Modulo G, dans le corps de Galois $CG(2^m)$ de polynôme générateur G, et une entrée de données paramétrable, pour ce polynôme générateur, comportant :
   - un décodeur (10) constitué d'une ligne de N cellules élémentaires identiques $CD_j$, ordonnées de j =

0 à N-1, recevant les coefficients du polynôme générateur G(N:0) et transmettant les coefficients de ce polynôme sans celui de degré le plus élevé G(N-1:0) et un polynôme degré à un coefficient significatif déduit par combinaison logique du polynôme générateur marquant le degré m du corps de Galois choisi, DG(N-1:0) ;

- une matrice de calcul (20) constituée de p lignes de cellules de calcul élémentaires identiques pour effectuer le calcul polynomial en p étapes, les cellules de la dernière ligne fournissant les termes de degrés 0 à m-1 du polynôme résultat P,

caractérisé en ce que, pour un calcul en p = 2N-1 étapes, la matrice de calcul comporte 2n-1 lignes de i = 0 à 2(N-1) et N colonnes de j = 0 à N-1 de cellules $CM_{i,j}$ connectées de manière arborescente, les entrées non connectées recevant des niveaux "0" logique, chaque cellule élémentaire de calcul $MC_{i,j}$ comportant :

- cinq entrées verticales reliées aux sorties verticales de la cellule précédente de la même colonne, recevant les termes de degré j, G(j) DG(j) et B(j) du polynôme générateur, du polynôme degré, et du polynôme B, le terme de degré i-j du polynôme A, et le terme de degré j d'un résultat intermédiaire $z^{i-1}(j)$, deux entrées latérales recevant de la cellule de la colonne de rang inférieur de la même ligne le terme de degré j-1 du résultat intermédiaire $z^{i-1}(j-1)$ et le terme de degré (i + 1 - j), A(i + 1 - j), du polynôme A,
- deux sorties latérales à destination de la cellule de rang supérieur de la même ligne fournissant le terme de degré j du résultat intermédiaire $z^{i-1}(j)$ et le terme de degré i-j, A(i-j) du polynôme A.

**2.** Multiplieur-additionneur selon la revendication 1, caractérisé en ce que chaque cellule élémentaire $CD_j$ du décodeur (10) a une entrée verticale pour le terme de degré j du polynôme générateur G, G(j), deux entrées latérales, provenant de la cellule de rang supérieur $CD_{j+1}$, recevant respectivement le terme de degré j + 1 de G, G(j + 1) et un élément binaire dit de détection de degré DD(j + 1), et reliées d'une part aux entrées respectivement directe et inversée d'une porte ET logique 12 fournissant le terme de degré j du polynôme marquant le degré du polynôme générateur, DG(j) sur une sortie verticale, et d'autre part aux entrées d'une porte OU logique (11) fournissant l'élément binaire de détection de degré à la cellule suivante, DD(j) sur une première sortie latérale, le terme de degré j de G, G(j) étant transmis par cette cellule à une sortie verticale et à une seconde sortie latérale, à destination de la cellule de rang inférieur, la cellule de rang le plus élevé $CD_{N-1}$ recevant G(N), et 0 sur son entrée latérale DD(J + 1).

**3.** Multiplieur-additionneur selon la revendication 2, caractérisé en ce que le circuit logique de calcul de chaque cellule élémentaire de calcul $CM_{i,j}$ comporte :

- une porte trois états 21 reliée à l'entrée $z^{i-1}(j)$ et commandée par DG(j) dont la sortie est reliée à une ligne de connexion entre cellules $R_i$ d'une même ligne pour transmettre $Z^{i-1}(m-1)$ à toutes les cellules de la ligne i,
- des moyens de combinaison logique comportant une porte ET (26) pour calculer A(i-j) B(j), une porte NON ET (22) et une porte OU exclusif inversée (23) pour calculer $z^i(j) = z^{i-1}(j-1) + G(j) z^{i-1)}(m-1)$, une porte ET (28) dont une entrée reçoit $z^i(j)$ et l'autre $Z_j = \sum_i A(i-j)B(j)$ prélevé dans une zone de câblage ligne s'étendant entre deux lignes consécutives, chaque cellule comportant en outre, pour le calcul de $Z_i$, une porte OU exclusif (27) ayant ses entrées et sa sortie dans la zone de câblage ligne, et une zone de câblage colonne s'étendant entre deux colonnes consécutives, dans laquelle est connectée la sortie de la porte ET fournissant $Z_i\, z^i(j)$, chaque cellule comportant en outre une porte OU exclusif (29) ayant ses entrées et sa sortie dans la zone de câblage entre colonnes, pour le calcul de $P(j) = \sum_i Z_i\, z^i(j) + C(j)$,

et en ce que le terme A(0) est appliqué à l'entrée A(i-j) de la cellule $MC_{0,0}$, les termes A(i), pour i = 1 à m-1, étant respectivement appliqués aux entrées A(i + 1-j) des cellules $MC_{i,0}$ pour i = 0 à m-2.

**4.** Utilisation d'un multiplieur-additionneur paramétrable, selon l'une des revendications 1 à 3 dans un processeur de traitement de signal numérique, pour le codage et le décodage d'information par codes détecteurs correcteurs d'erreurs, à valeurs dans les corps de Galois.

## Patentansprüche

1. Parametrierbarer Multiplizierer-Addierer in den Galois- Körpern bis zu $CG(2^N)$, wobei N eine vorgegebene ganze Zahl ist und drei Vielfacheingänge vorgesehen sind zum Empfang der Koeffizienten von Operandenpolynomen A, B, C eines Grads m-1 kleiner als N für die Polynomoperation P im Galoiskörper des Grads m, $CG(2^m)$: $P = (A*B) + C$, wobei $*$ und $+$ die Multiplikation und die Addition modulo G des Erzeugendenpolynoms G im Galois-Körper $CG(2^m)$ bedeuten und wobei weiter ein parametrierbarer Dateneingang für dieses Erzeugendenpolynom vorgesehen ist und der Multiplizierer-Addierer aufweist:
   - einen Dekodierer (10) bestehend aus einer Zeile von N gleichen Elementarzellen $CD_j$, die mit j = 0 bis j = N-1 bezeichnet sind und die Koeffizlenten des Erzeugendenpolynomens G(N:0) empfangen und die Koeffizienten dieses Polynoms ohne das Polynom mit höchstem Grad G(N-1:0) sowie ein Gradpolynom mit einem signifikativen Koeffizienten übertragen, der durch logische Kombination des Erzeugendenpolynoms, das den Grad m des gewählten Galois-Körpers DG(N-1:0) markiert, abgeleitet ist,
   - eine Rechenmatrix (20) bestehend aus p Zeilen von gleichen Elementarrechenzellen, um die Polynomberechnung in p Schritten durchzuführen, wobei die Zellen der letzten Zeile die Angaben der Grade 0 bis m-1 des Ergebnispolynomens P liefern,

   dadurch gekennzeichnet, daß für eine Berechnung in p = 2N-1 Schritten die Rechenmatrix 2n-1 Zeilen von i = 0 bis i = 2(N-1) Zeilen und N Spalten von j = 0 bis j = N-1 von Zellen $CM_{i,j}$ besitzt, die in Form einer Baumstruktur angeschlossen sind, wobei die nicht angeschlossenen Eingänge die logischen Pegel "0" empfangen und jede elementare Rechenzelle $MC_{i,j}$ enthält:
   - fünf senkrechte, an die senkrechten Ausgänge der vorhergehenden Zelle in derselben Spalte angeschlossene Eingänge, die die Angaben des Grads j, nämlich G(j), DG(j) und B(j) des Erzeugendenpolynoms, des Gradpolynoms und des Polynoms B sowie die Angabe des Grads i-j des Polynoms A und die Angabe des Grads j eines Zwischenresultats $z^{i-1}(j)$ empfangen, wobei zwei seitliche Eingänge der Zelle von der Spalte des nächstniedrigeren Rangs derselben Zeile die Angabe des Grads j-1 des Zwischenresultats $z^{i-1}(j)$ und die Angabe des Grads (i+1-j), A(i-1-j) des Polynoms A empfangen
   - zwei seitliche Ausgänge in Richtung auf die Zelle des nächsthöheren Rangs in derselben Zeile, die die Angabe des Grads j des Zwischenergebnisses $z^{i-1}(j)$ und die Angabe des Grads i-j, A(i-j) des Polynoms A liefern.

2. Multiplizierer-Addierer nach Anspruch 1, dadurch gekennzeichnet, daß jede Elementarzelle $CD_j$ des Dekodierers (10) einen senkrechten Eingang für die Angabe des Grads j des Erzeugendenpolynoms G, G(j), zwei seitliche Eingänge, die von den Zellen des nächsthöheren Rangs $CD_{j+1}$ kommen und die Angabe des Grads j+1 von G, G(j+1) sowie ein Binärelement empfangen, des Graderfassungsbit DD(j+1) genannt wird, und die einerseits an den direkten bzw. inversen Eingang eines logischen UND-Tors (12) angeschlossen sind, das die Angabe des Grads j des den Grad der Erzeugendenpolynoms DG(j) markierenden Polynoms an einen senkrechten Ausgang liefert, und die andererseits an die Eingänge eines logischen ODER-Tors (11) angeschlossen sind, das das binäre Erfassungselement des Grads der nächstfolgenden Zelle DD(j) an einen ersten seitlichen Ausgang liefert, wobei die Angabe des Grads j von G, G(j) durch diese Zelle an einen senkrechten Ausgang und an einen zweiten seitlichen Ausgang übertragen wird in Richtung auf die Zelle des nächstniedrigeren Rangs, während die Zelle höchsten Rangs $CD_{N-1}$ die Angabe G(N) und an ihrem Seiteneingang DD(J+1) den Wert 0 empfängt.

3. Multiplizierer-Addierer nach Anspruch 2, dadurch gekennzeichnet, daß der logische Rechenkreis jeder elementaren Rechenzelle $CM_{i,j}$ aufweist:
   - ein Dreizustandstor (21), das an den Eingang $z^{i-1}(j)$ angeschlossen ist und von DG(j) gesteuert wird und ausgangsseitig an eine Verbindungsleitung zwischen Zellen $R_i$ einer gemeinsamen Zeile angeschlossen ist, um $Z^{i-1)}(m-1)$ an alle Zellen der Zeile i zu übermitteln,
   - logische Verknüpfungsmittel mit einem UND-Tor (26) zur Berechnung von A(i-j)B(j), einem NICHT-UND-Tor (22) und einem invertierenden Exklusiv-ODER-Tor (23) zur Berechnung von $z^i(j) = z^{i-1}(j-1)$

     $+ G(j) z^{i-1}(m-1)$, einem UND-Tor (28), das an einem Eingang $z^i(j)$ und am anderen Eingang $z_j = \sum$ A(i-j)B(j) empfangt, wobei dieser Wert in einer Zeilenverdrahtungszone erhoben wird, die sich zwischen zwei aufeinanderfolgenden Zeilen erstreckt, wobei jede Zelle weiter für die Berechnung von $Z_i$ ein Exklusiv-ODER-Tor (27), dessen Eingange und Ausgang in der Zeilenverdrahtungszone liegen, und eine Spaltenverdrahtungszone aufweist, die sich zwischen zwei aufeinanderfolgenden Spalten

erstreckt und in der der Ausgang des UND-Tors, das den Wert $Z_iz^i(j)$ liefert, wobei jede Zelle weiter ein Exklusiv-ODER-Tor (29) enthält, dessen Eingange und Ausgang in der Spalten-Verdrahtungszone liegen und das den folgenden Wert berechnet $P(j) = \sum_i z_iz^i(j) + C(j)$, und dadurch, daß die Angabe A(0) an den Eingang A(i-j) der Zelle $MC_{0,0}$ angelegt wird, während die Angaben A(i) für $1 \leqq i \leqq m-1$ an die Eingänge A(i + 1-j) der Zellen $MC_{i,0}$ für $0 \leqq i \leqq m-2$ angelegt werden.

4. Verwendung eines parametrierbaren Multiplizierers-Addierers nach einem der Ansprüche 1 bis 3 in einem digitalen Signalverarbeitungsprozessor zur Kodierung und Dekodierung von Informationen mittels Fehlererkennungs- und -korrekturkodes, deren Werte in den Galois-Körpern liegen.

## Claims

1. Multiplier-adder parameterisable in Galois fields up to $CG(2^N)$ where N is a predetermined integer, with three multiple inputs for receiving the coefficients of operand polynomials A, B, C, of degree m-1 lower than N for the polynomial operation P in the Galois field of degree m, $CG(2^m)$ : P = (A ∗ B) + C, where ∗ and + are multiplication and addition respectively, performed modulo G, in the Galois field CG(2m) of generating polynomial G, and a parameterisable data input, for this generating polynomial, comprising:
   - a decoder (10) consisting of a row of N identical elementary cells $CD_j$, ordered from j = 0 to N-1, receiving the coefficients of the generating polynomial G(N:0) and transmitting the coefficients of this polynomial without that of the highest degree G(N-1:0) and a degree polynomial with a significant coefficient deduced by logical combination of the generating polynomial marking the degree m of the chosen Galois field, DG(N-1:0);
   - a calculating matrix (20) consisting of p rows of identical elementary calculating cells for performing polynomial calculation in p steps, the cells of the last row providing the terms of degrees 0 to m-1 of the result polynomial P,
     characterised in that, for calculation in p = 2N-1 steps, the calculating matrix comprises 2n-1 rows from i = 0 to 2(N-1) and N columns from j = 0 to N-1 of cells $CM_{i,j}$ connected in tree fashion, the unconnected inputs receiving logic levels of "0," each elementary calculating cell $MC_{i,j}$ comprising:
   - five vertical inputs connected to the vertical outputs of the preceding cell of the same column, receiving the terms of degree j, G(j) DG(j) and B(j) of the generating polynomial, of the degree polynomial, and of the polynomial B, the term of degree i-j of the polynomial A, and the term of degree j of an intermediate result $z^{i-1}(j)$, two lateral inputs receiving from the cell of the column of lower rank of the same row the term of degree j-1 of the intermediate result $z^{i-1}(j-1)$ and the term of degree (i + 1 - j), A(i + 1 - j), of the polynomial A,
   - two lateral outputs destined for the cell of higher rank of the same row providing the term of degree j of the intermediate result $z^{i-1}(j)$ and the term of degree i-j, A(i-j) of the polynomial A.

2. Adder-multiplier according to claim 1, characterised in that each elementary cell $CD_j$ of the decoder (10) has a vertical input for the term of degree j of the generating polynomial G, G(j), wherein two lateral inputs which come from the cell of higher rank $CD_{j+1}$ respectively receive the term of degree j + 1 of G, G(j + 1) and a so-called degree detection binary element DD(j + 1) and are connected on the other hand to the direct and inverse inputs respectively of a logical AND gate 12 providing the term of degree j of the polynomial marking the degree of the generating polynomial, DG(j) at a vertical output, and on the other hand to the inputs of a logical OR gate (11) providing the degree detection binary element to the following cell, DD(j) at a first lateral output, the term of degree j of G, G(j) being transmitted by this cell to a vertical output and to a second lateral output, destined for the cell of lower rank, the cell of highest rank $CD_{N-1}$ receiving G(N), and 0 at its lateral input DD(J + 1).

3. Multiplier-adder according to claim 2, characterised in that the logical calculating circuit of each elementary calculating cell $CM_{i,j}$ comprises:
   - a gate with three states 21 connected to the input $z^{i-1}(j)$ and controlled by DG(j) of which the output is connected to a connecting line between cells $R_i$ of the same row for transmitting $Z^{i-1}(m-1)$ to all the cells of the row i,
   - logic combination means comprising an AND gate (26) for calculating A (i-j) B(j), a NAND gate (22) and an inverse exclusive-OR gate (23) for calculating $Z^i(j-1) = z^{i-1}(j-1) + G(j)\, z^{i-1}(m-1)$, an AND gate (28) of which one input receives $z^i(j)$ and the other $Z_j = \Sigma_i A(i-j)B(j)$ taken from a row wiring zone extending between two consecutive rows, each cell further comprising, for the calculation of $Z_i$, an exclusive-OR gate (27) having its inputs and its output in the row wiring zone, and a column wiring zone extending between two consecutive columns, in which is connected the output of the AND gate providing $Z_i\ z^i(j)$, each cell further comprising an exclusive-OR gate (29) having its inputs and its output in the zone for wiring between columns, for the calculation of $P(j) = \Sigma_i Z_i\ z^i(j) + C(j)$
and in that the term A(0) is applied to the input A(i-j) of the cell $MC_{0,0}$, the terms A(i), where i = 1 to m-1, being respectively applied to the inputs A(i + 1-j) of the cells $MC_{i,0}$ where i = 0 to m-2.

4. Use of a parameterisable multiplier-adder, according to any of claims 1 to 3 in a digital signal processor, for the coding and decoding of information by error detecting and correcting codes, with values in Galois fields.

FIG 1

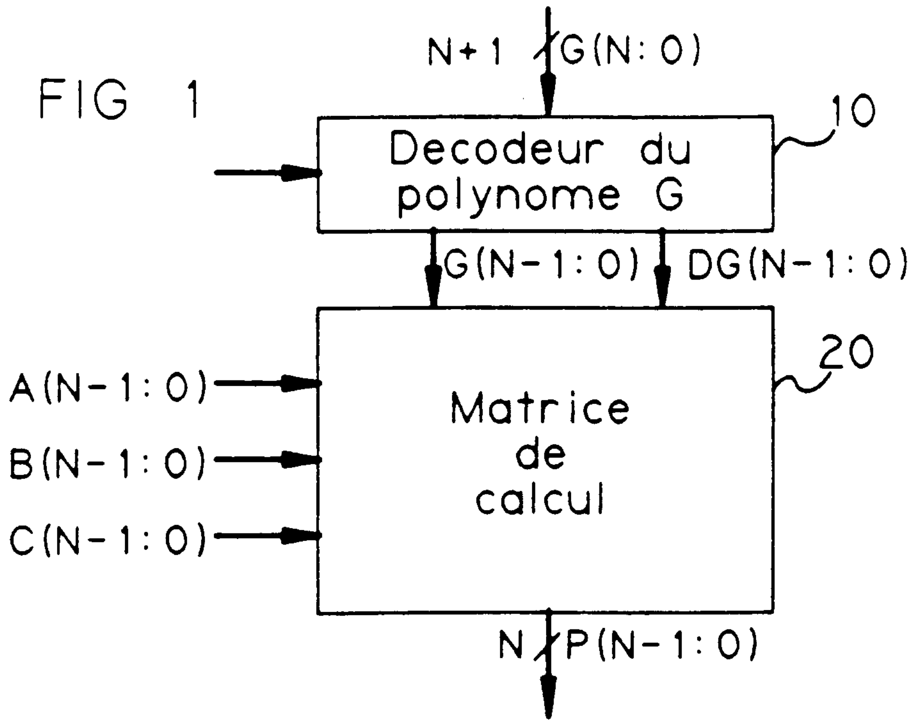


FIG 2

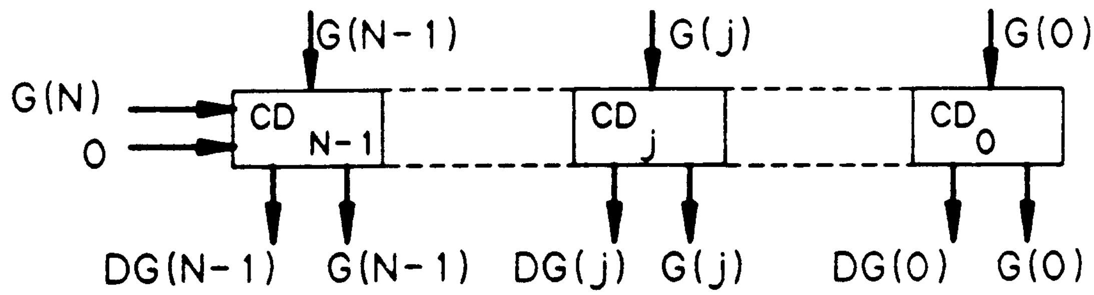


FIG 3

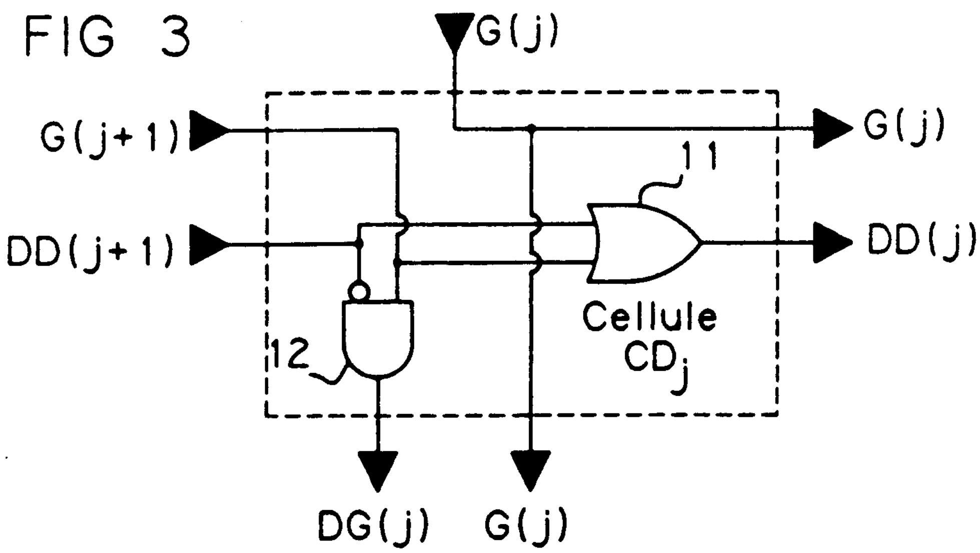

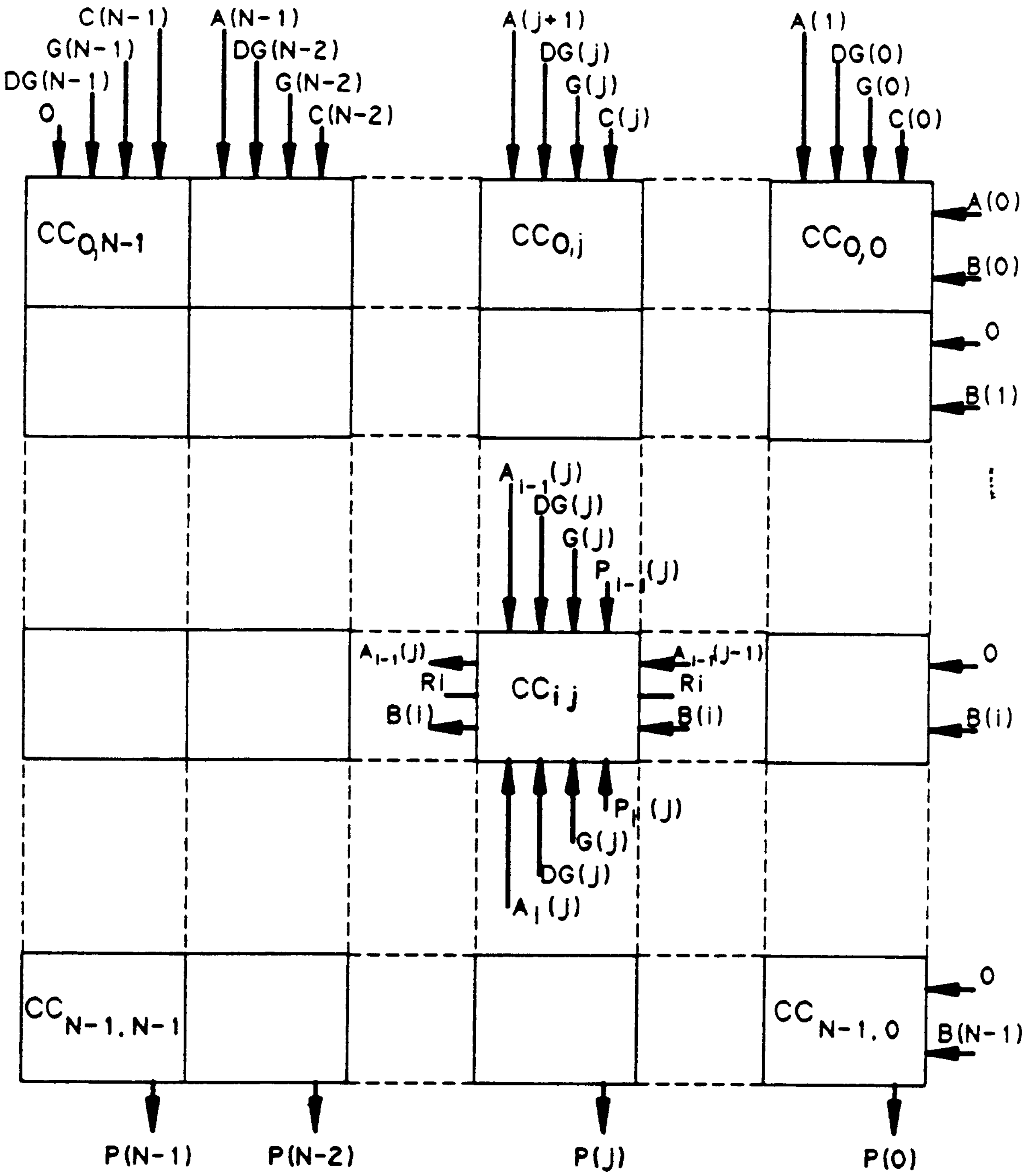
C(N-1)
G(N-1)
DG(N-1)
0
A(N-1)
DG(N-2)
G(N-2)
C(N-2)
A(j+1)
DG(j)
G(j)
C(j)
A(1)
DG(0)
G(0)
C(0)
A(0)
B(0)
0
B(1)
$CC_{0,N-1}$
$CC_{0,j}$
$CC_{0,0}$
$A_{i-1}(j)$
DG(j)
G(j)
$P_{i-1}(j)$
$A_{i-1}(j)$
Ri
B(i)
$CC_{ij}$
$A_{i-1}(j-1)$
Ri
B(i)
0
B(i)
$P_i(j)$
G(j)
DG(j)
$A_i(j)$
$CC_{N-1,N-1}$
$CC_{N-1,0}$
0
B(N-1)
P(N-1)
P(N-2)
P(j)
P(0)

FIG 4

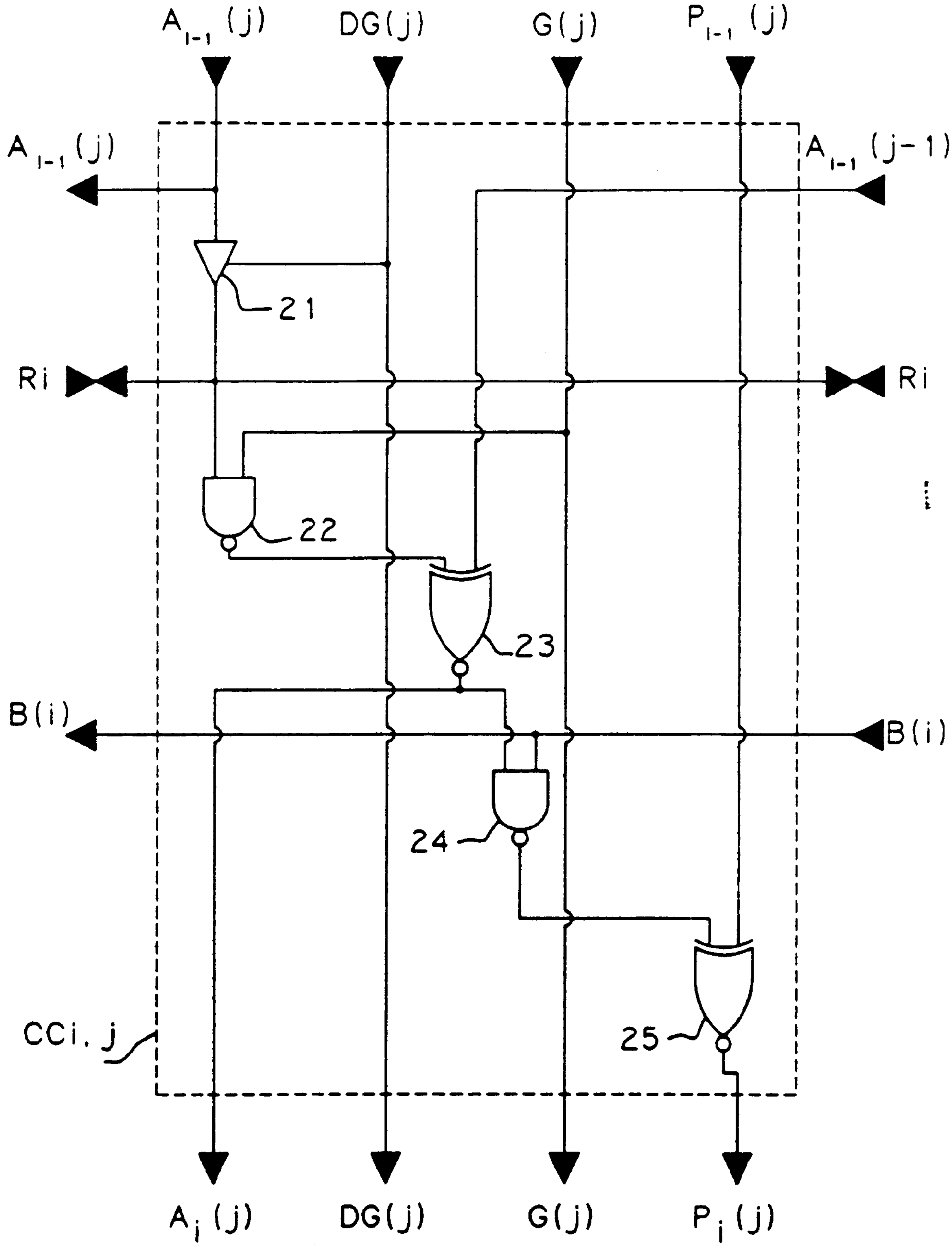
$A_{i-1}$ (j)
DG(j)
G(j)
$P_{i-1}$ (j)
$A_{i-1}$(j)
$A_{i-1}$ (j-1)
21
Ri
Ri
22
23
B(i)
B(i)
24
25
CCi, j
$A_i$ (j)
DG(j)
G(j)
$P_i$ (j)

FIG 5

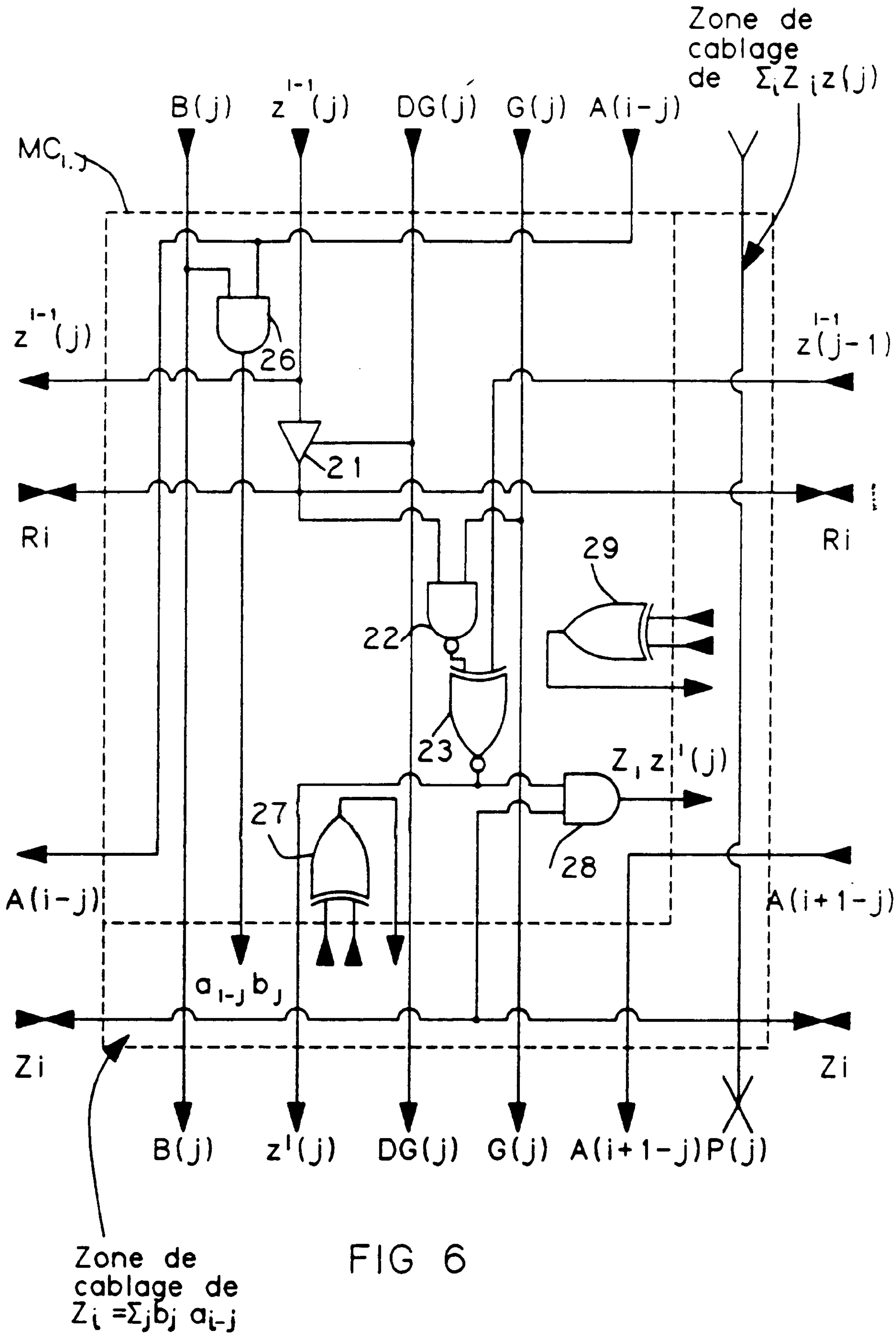
Zone de cablage de $\Sigma_i Z_i z(j)$
B(j)
$z^{i-1}(j)$
DG(j)
G(j)
A(i-j)
$MC_{i,j}$
$z^{i-1}(j)$
26
$z^{i-1}(j-1)$
21
Ri
Ri
29
22
23
$Z_i z^i(j)$
27
28
A(i-j)
A(i+1-j)
$a_{i-j} b_j$
Zi
Zi
B(j)
$z^i(j)$
DG(j)
G(j)
A(i+1-j)
P(j)
Zone de cablage de $Z_i = \Sigma_j b_j a_{i-j}$

FIG 6

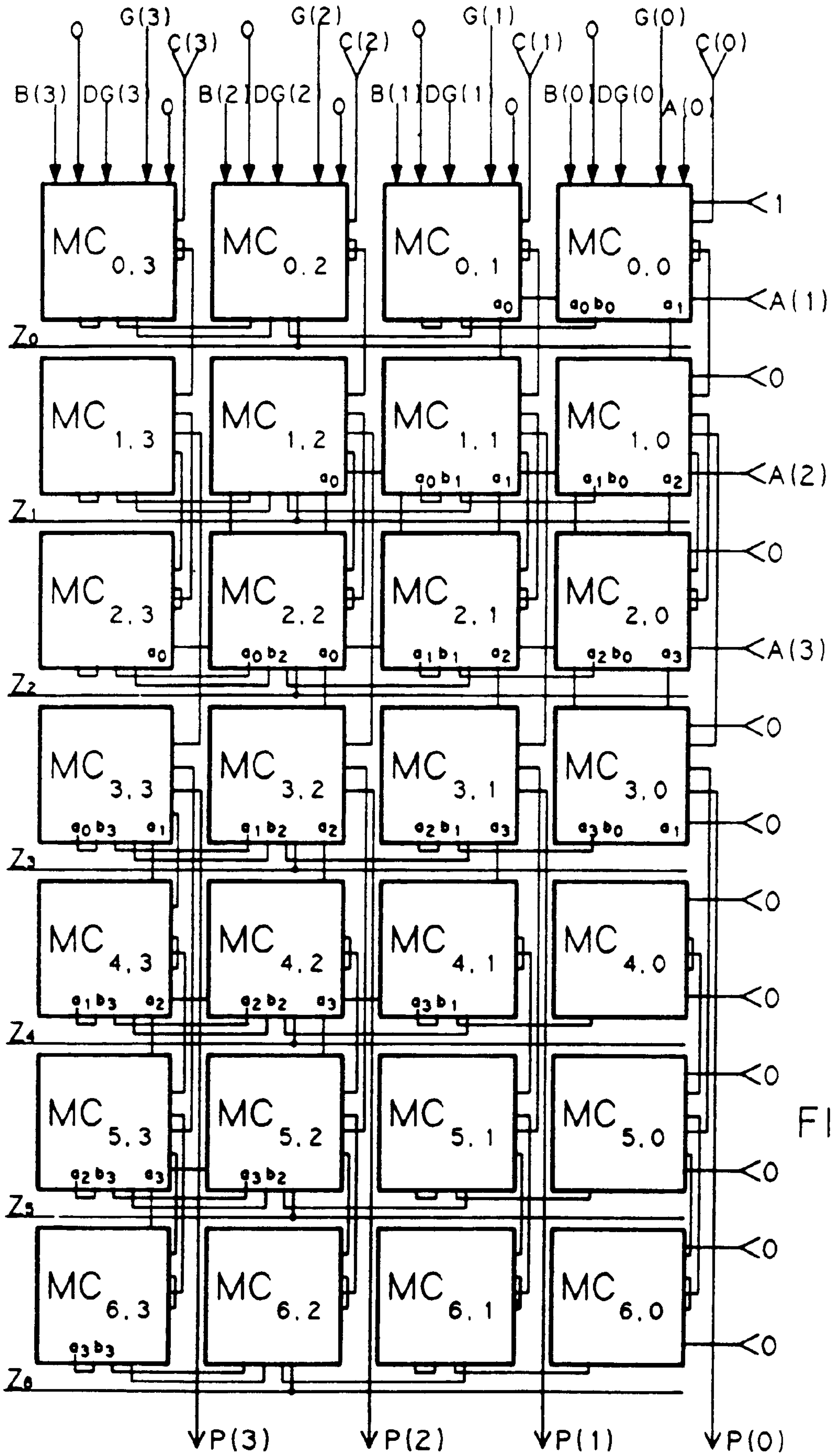
G(3)
G(2)
G(1)
G(0)
C(3)
C(2)
C(1)
C(0)
B(3)
DG(3)
B(2)
DG(2)
B(1)
DG(1)
B(0)
DG(0)
A(0)
A(1)
A(2)
A(3)
MC 0,3
MC 0,2
MC 0,1
MC 0,0
MC 1,3
MC 1,2
MC 1,1
MC 1,0
MC 2,3
MC 2,2
MC 2,1
MC 2,0
MC 3,3
MC 3,2
MC 3,1
MC 3,0
MC 4,3
MC 4,2
MC 4,1
MC 4,0
MC 5,3
MC 5,2
MC 5,1
MC 5,0
MC 6,3
MC 6,2
MC 6,1
MC 6,0
Z0
Z1
Z2
Z3
Z4
Z5
Z6
P(3)
P(2)
P(1)
P(0)

FIG 7